# EUROPÄISCHE PATENTANMELDUNG

(11) **EP 0 967 635 A2**
(43) Veröffentlichungstag der Anmeldung: **29.12.1999**
(21) Anmeldenummer: 99110244.3
(22) Anmeldetag: 27.05.1999
(51) Int. Cl.: H01L 21/48, H01L 23/495, H01L 23/498, H01L 23/538

(54) **Verfahren zur Herstellung einer gebondeten, aluminiumhaltiges Material enthaltenden Vorrichtung**

(30) Priorität: 22.06.1998 DE 19827521
(71) Anmelder: W.C. Heraeus GmbH & Co. KG, 63450 Hanau (DE)
(72) Erfinder: Frey, Thomas, 63456 Hanau (DE); Krüger, Frank, Dr., 63486 Bruchköbel (DE); Herklotz, Günter, Dr., 63486 Bruchköbel (DE)
(74) Vertreter: Kühn, Hans-Christian

(57) **Zusammenfassung**

Es wird ein Verfahren zur Herstellung einer gebondeten, aluminlumhaltiges Material enthaltenden Vorrichtung bereitgestellt, wobei ein aluminiumhaltiges Material, insbesondere Aluminiumdraht, auf ein Substrat gebondet wird und das Substrat eine bondbare metallische Beschichtung aufweist, die eine Nickel enthaltende Schicht und eine die Oberfläche der Beschichtung bildende, Gold enthaltende Schicht umfaßt, das dadurch gekennzeichnet ist, daß die Beschichtung eine Kombination aus einer Nickel- oder Nickellegierungs-Schicht, einer Palladium- oder Palladiumlegierungs-Schicht und einer Gold- oder Goldlegierungs-Schicht ist und die Palladium- oder Palladiumlegierungs-Schicht zwischen der Nickel- oder Nickellegierungs-Schicht und der Gold- oder Goldlegierungs-Schicht angeordnet ist.

## Beschreibung

Die Erfindung betrifft ein Verfahren zur Herstellung einer gebondeten aluminiumhaltiges Material enthaltenden Vorrichtung, eine entsprechende Vorrichtung und die Verwendung eines Substrats.

DE 44 31 847 A1 offenbart u. a. ein Substrat mit bondfähiger metallischer Beschichtung, die eine Nickel enthaltende Schicht und eine die Oberfläche der Beschichtung bildende, Gold enthaltende Schicht umfaßt, wobei die Beschichtung eine Kombination aus einer Nickel- oder Nickellegierungs-Schicht, einer Palladium enthaltenden Schicht und einer Gold- oder Goldlegierungs-Schicht ist und die Gold- oder Goldlegierungs-Schicht eine Dicke von 0,01 bis 0,5 µm aufweist. Dieses Substrat dient ausschließlich zum Bonden von Golddrähten. Diese Drähte sind aufgrund ihres Materials sehr kostspielig.

In DE 41 23 911 C wird ein chemisch vernickeltes DCB-Substrat ("Direkt-Copper-Bonding") beschrieben, das durch Bonden mit dünnen Drähten aus Aluminium verbunden werden kann. Die Nickelschicht ist vorzugsweise 7 bis 15 µm dick und kann mit einer hauchdünnen, größenordnungsmäßig 0,1 µm dicken Goldschicht überzogen sein, um sie vor Oxidation zu schützen. Das Al-Drahtbonden erfolgt mit Hilfe eines nadelförmigen Bond-Werkzeuges durch Reibschweißen mit Ultraschallunterstützung. Nachteilig bei diesem Substrat ist die starke Abhängigkeit der Bondqualität von der Qualität der aufgebrachten Goldschicht, die bei minderer Qualität wiederum häufig auf prozeßtechnisch schlecht geführte Goldbäder zurückzuführen ist.

Aus dem Vorgenannten ergibt sich das Problem, mit Hilfe eines neuartigen Verfahrens, einer neuartigen Vorrichtung und einer Verwendung eines Substrats die oben genannten Nachteile zumindest teilweise zu beseitigen.

Dieses Problem wird erfindungsgemäß durch ein Verfahren nach Anspruch 1, eine Vorrichtung nach Anspruch 15 und eine Verwendung nach Anspruch 16 gelöst.

Überraschenderweise ist es nach dem erfindungsgemäßen Verfahren möglich, aluminiumhaltiges Material enthaltende Vorrichtungen herzustellen, wobei ein aluminiumhaltiges Material, insbesondere Aluminiumdraht, auf ein Substrat gebondet wird, das eine Beschichtung aus drei Schichten aufweist. An der äußeren Oberfläche befindet sich eine Gold enthaltende Schicht, darunter eine Palladium enthaltende Schicht, wobei unter dieser wiederum eine weitere Schicht, nämlich eine Nickel enthaltende, angeordnet ist.

Durch das Zusammenwirken dieser drei Schichten besteht quasi keine Abhängigkeit der Bondqualität für aluminiumhaltige Materialien, insbesondere für Aluminiumdrähte, von der Qualität der Goldschicht. Dies führt zu einer prozeßtechnisch gesehen möglichen vereinfachten Verfahrensweise zur Aufbringung einer Goldschicht, was sich u. a. in niedrigeren Kosten widerspiegelt. Hinzu kommt die Kostenersparnis durch Verwendung von aluminiumhaltigen Materialien, insbesondere von Aluminiumdrähten, ohne auf entsprechend goldhaltige Materialien, insbesondere Golddrähte, zurückgreifen zu müssen.

Die erfindungsgemäßen Vorrichtungen, die hergestellt werden durch Bonden von insbesondere Aluminiumdrähten auf Substrate mit entsprechender Abfolge der oben genannten Schichten weisen im Vergleich zu Nickel-Gold-Schichten enthaltende, mit insbesondere Aluminiumdraht gebondeten Vorrichtungen eine erheblich höhere Stabilität bezüglich der einzelnen Bondpunkte auf. Dies äußert sich u. a. in einer nahezu fehlenden sogenannten Abheberrate bei Durchführung von physikalischen Haftfestigkeitsprüfungen zwischen Substrat und Draht.

In besonders vorteilhafter Weise hat es sich bewährt, wenn die Gold- oder Goldlegierungs-Schicht eine Dicke von 0,01 bis 0,5 µm, die Palladium- oder Palladiumlegierungs-Schicht eine Dicke von 0,01 bis 0,5 µm und die Nickel- oder Nickellegierungs-Schicht eine Dicke von 1 bis 10 µm aufweist.

Weiterhin sind die folgenden Ausgestaltungen vorteilhaft, da sich diese in der Praxis bewährt haben.

Die Goldlegierung ist eine Gold-Eisen-, Gold-Kobalt- oder Gold-Nickel-Legierung.

Die Nickellegierung ist eine Nickel-Bor-, Nickel-Phosphor-, Nickel-Eisen-Phosphor-, Nickel-Phosphor-Wolfram-, Nickel-Kobalt-Phosphor- oder Nickel-Wolfram-Legierung.

In vorteilhafter Weise eignet sich besonders Palladium, eine Palladium-Nickel-Legierung mit 10 bis 40 Gewichts-% Nickel und eine Palladium-Silber-Legierung mit 10 bis 50 Gewichts-% Silber und darunter angeordnetem Haft-Palladium für die Bildung der Palladium enthaltenden Schicht. Im erfindungsgemäßen Kontext ist unter der Bezeichnung Haft-Palladium eine dünne Palladium-Schicht zu verstehen, die die Haftung der Palladium-Silber-Legierung auf der Nickel- oder Nickellegierungs-Schicht verstärkt. Die Schichtdicke des Haft-Palladiums beträgt in vorteilhafterweise 0,01 bis 0,1 µm.

Weiterhin weist die Gold- oder Goldlegierungs-Schicht vorteilhafterweise eine Dicke von 0,05 bis 0,1 µm, die Palladium- oder Palladiumlegierungs-Schicht eine Dicke von 0,05 bis 0,2 µm und die Nickel- oder Nickellegierungs-Schicht eine Dicke von 2 µm auf.

Bilden die Schichten die bondfähige Beschichtung eines Leiterrahmens, so besteht das Substrat vorzugsweise aus Kupfer, Kupfer-Legierungen, wie CuFe und CuBe, Nickel- oder Nickel-Legierungen wie NiFe.

Für den Einsatz des beschichteten Substrats als Leiterplatte aus bondfähiger Oberfläche werden für das Substrat Metall/Kunststoff-Verbundwerkstoffe verwendet, besonders mit Kupfer-Metallisierungen versehene Polyimide und insbesondere glasfaserverstärkte Epoxydharze.

Die nach dem erfindungsgemäßen Verfahren hergestellten Vorrichtungen weisen die oben angegebenen überraschenden und vorteilhaften Eigenschaften auf.

Entsprechendes gilt auch für die Verwendung eines erfindungskontext-bezogenen Substrats mit entsprechender Schichtabfolge zum Bonden von aluminiumhaltigen Materialien, insbesondere von Aluminiumdrähten.

Die nachfolgenden Beispiele dienen zur Erläuterung der Erfindung.

Erfindungsgemäß beschichtete Substrate werden mit Substraten bekannter Nickel-Gold-Beschichtung verglichen. Die Bondfähigkeit der beschichteten Substrate wird durch Bestimmung der Abreißkraft von damit verbundenen Bonddrähten geprüft.

In Tabelle I sind verschiedene Beschichtungstypen auf CuSn und deren physikalisch relevante Bondgrößen angegeben.

Die in der Tabelle 1 angegebenen Ergebnisse wurden mit den dort angegebenen Geräten und den entsprechenden Bedingungen erhalten. Das aluminiumenthaltende Material war in diesem Fall Reinstaluminiumdraht (Al-R) mit einem Durchmesser von 300 µm. Die angegebenen Ergebnisse stellen den Ausgangszustand direkt nach dem eigentlichen Bonden dar.

Unter der Verwendung der gemäß in der Tabelle angegebenen beschichteten Substrate und den entsprechenden Aluminiumbonddrähten wurden Bondanschlüsse nach dem Wedge-Wedge-Verfahren (Ultrasonic-Verfahren) hergestellt. Die Abreißkraft der Bondanschlüsse wurde durch sogenannte Pulltests bestimmt, wobei mittels eines kleinen Hakens bei stereomikroskopischer Betrachtung die Drahtschleife an der Bondstelle abgerissen und die dazu erforderliche Abreißkraft über eine Kraftmeßzelle registriert wurde. Die in den jeweiligen Pulltests ermittelten Minimum-, Maximum- und Mittelwerte der Abreißkraft sind in der Tabelle angegeben.

In Tabelle II sind die zu in Tabelle 1 entsprechenden Substraten und Testbedingungen jeweils erhaltene Ergebnisse angegeben, wobei in diesem Fall die Abreißkraft der Bondanschlüsse nach Durchlaufen einer Auslagerung von 250 Stunden bei einer Temperatur von T = + 85 °C und einer relativen Luftfeuchtigkeit von 85 % erhalten wurden. Die Auslagerungsbedingungen stellen eine Art künstliche Alterung dar und sind somit ein Maß für die Beurteilung der Haftfestigkeit der Bondanschlüsse nach einer gewissen Lebensdauer.

Unter V 0 und V 1 sind die einzelnen Ergebnisse dargestellt, die bei einem sehr gut eingestellten Gold- bzw. Palladiumbad erhalten werden. Bei V 2 bis V 9 sind einzelne Prozeßparameter bewußt ungünstig eingestellt.

Bei V 2 und V 6 ist der pH-Wert des Gold-Elektrolyten zu niedrig.

Bei V 3 und V 7 ist der Goldgehalt des Elektrolyten zu gering.

Bei V 4 und V 8 ist die kathodische Stromdichte zur Abscheidung der Goldschicht zu hoch.

Bei V 5 und V 9 ist die Goldbad-Temperatur zu gering.

Aus den Tabellen ist zu erkennen, daß konventionell mit Nickel/Gold-beschichtete Substrate im Vergleich zu erfindungsgemäß beschichteten Substraten (Nickel/Palladium/Gold) eine erheblich geringere Haftfestigkeit der gebondeten Aluminiumdrähte aufweisen. Dies äußert sich in einer relativ hohen Abheber-Quote, die im allgemeinen bei weit über 30 % liegt (bei einem Abheber wird der gebondete Al-Draht durch Krafteinwirkung direkt vom Substrat abgehoben). Bei den erfindungsgemäß beschichteten Substraten sind sowohl im Ausgangszustand als auch nach Auslagerung keine Ausfälle durch Abheber zu konstatieren, während nach Auslagerung die konventionell beschichteten Substrate einen Totalausfall (100 %-ige Abheber-Rate) verzeichnen.

Aus den Tabellen ist somit die überlegende Haftfestigkeit der mit Aluminiumdraht gebondeten erfindungsgemäß beschichteten Substrate im Vergleich zu konventionell mit Nickel/Gold beschichteten Substraten aufgezeigt. Somit wird bei den erfindungsgemäßen Substraten die erheblich geringere Abhängigkeit der Bondqualität von der Qualität der aufgebrachten Goldschicht, die wiederum von der Prozeßführung abhängt, exemplarisch dokumentiert.

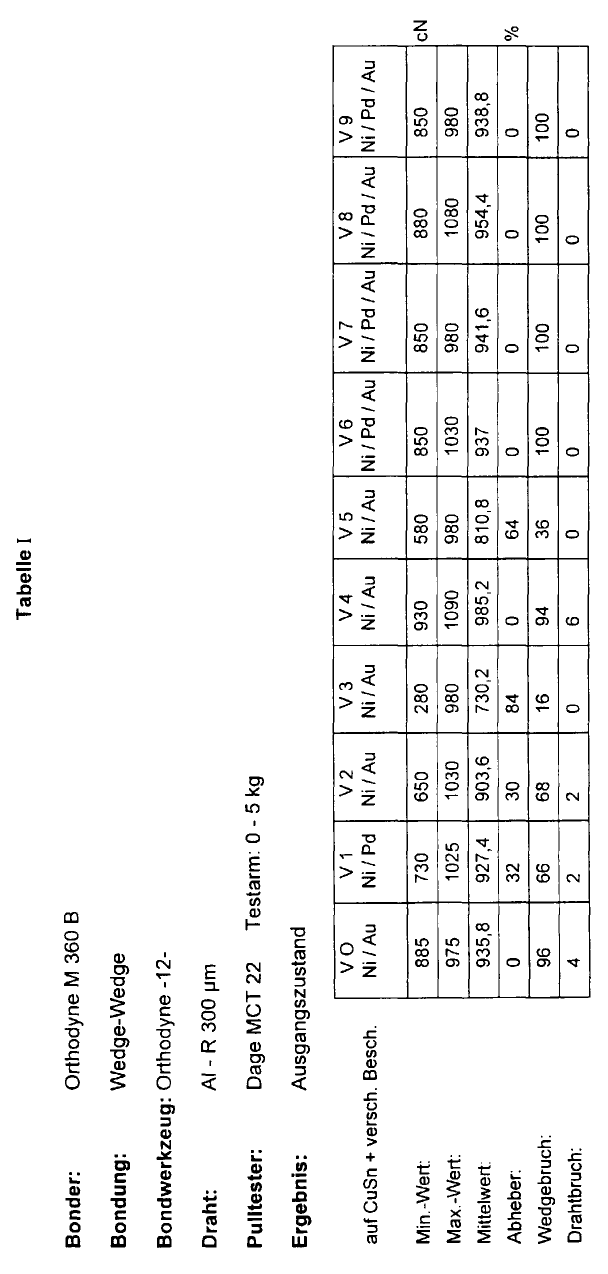

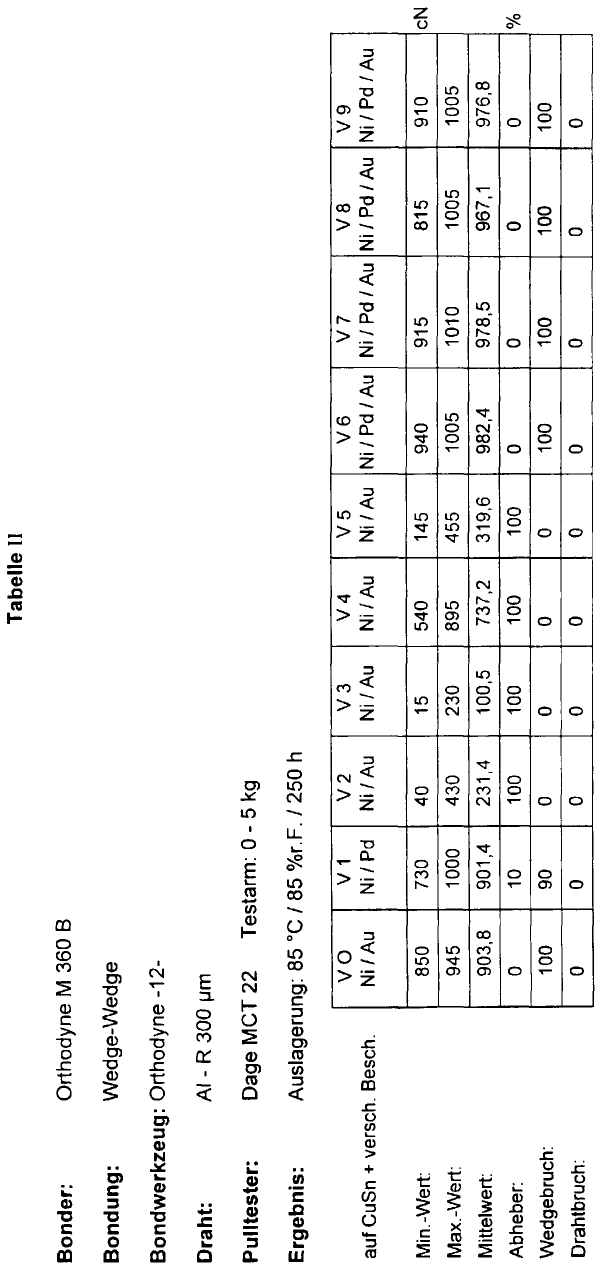

## Patentansprüche

1. Verfahren zur Herstellung einer gebondeten, aluminiumhaltiges Material enthaltenden Vorrichtung, wobei ein aluminiumhaltiges Material, insbesondere Aluminiumdraht, auf ein Substrat gebondet wird und das Substrat eine bondbare metallische Beschichtung aufweist, die eine Nickel enthaltende Schicht und eine die Oberfläche der Beschichtung bildende, Gold enthaltende Schicht umfaßt, dadurch gekennzeichnet, daß die Beschichtung eine Kombination aus einer Nickel- oder Nickellegierungs-Schicht, einer Palladium- oder Palladiumlegierungs-Schicht und einer Gold- oder Goldlegierungs-Schicht ist und die Palladium enthaltende Schicht zwischen der Nickel- oder Nickellegierungs-Schicht und der Gold- oder Goldlegierungs-Schicht angeordnet ist.

2. Verfahren nach Anspruch 1, dadurch gekennzeichnet, daß die Gold- oder Goldlegierungs-Schicht eine Dicke von 0,01 bis 0,5 µm aufweist.

3. Verfahren nach Anspruch 1 oder 2, dadurch gekennzeichnet, daß die Palladium- oder Palladiumlegierungs-Schicht eine Dicke von 0,01 bis 0,5 µm aufweist.

4. Verfahren nach einem der Ansprüche 1 bis 3, dadurch gekennzeichnet, daß die Nickel- oder Nickellegierungs-Schicht eine Dicke von 1 bis 10 µm aufweist.

5. Verfahren nach einem der Ansprüche 1 bis 4, dadurch gekennzeichnet, daß die Goldlegierung eine Gold-Eisen-, Gold-Kobalt- oder Gold-Nickel-Legierung ist.

6. Verfahren nach einem der Ansprüche 1 bis 5, dadurch gekennzeichnet, daß die Nickellegierung eine Nickel-Bor-, Nickel-Phosphor-, Nickel-Eisen-Phosphor-, Nickel-Phosphor-Wolfram-, Nickel-Kobalt-Phosphor- oder Nickel-Wolfram-Legierung ist.

7. Verfahren nach einem der Ansprüche 1 bis 6, dadurch gekennzeichnet, daß die Palladium enthaltende Schicht aus Palladium besteht.

8. Verfahren nach einem der Ansprüche 1 bis 6, dadurch gekennzeichnet, daß die Palladium enthaltende Schicht aus einer Palladium-Nickel-Legierung mit 10 bis 40 Gewichts-% Nickel besteht.

9. Verfahren nach einem der Ansprüche 1 bis 6, dadurch gekennzeichnet, daß die Palladium enthaltende Schicht aus einer Palladium-Silber-Legierung mit 10 bis 50 Gewichts-% Silber und darunter angeordnetem Haft-Palladium besteht.

10. Verfahren nach Anspruch 9, dadurch gekennzeichnet, daß die Schichtdicke des Haft-Palladiums 0,01 bis 0,1 µm beträgt.

11. Verfahren nach einem der Ansprüche 1 bis 10, dadurch gekennzeichnet, daß die Gold- oder Goldlegierungs-Schicht eine Dicke von 0,05 bis 0,1 µm, die Palladium- oder Palladiumlegierungs-Schicht eine Dicke von 0,05 bis 0,2 µm und die Nickel- oder Nickellegierungs-Schicht eine Dicke von 2 µm aufweist.

12. Verfahren nach einem der Ansprüche 1 bis 11, dadurch gekennzeichnet, daß das Substrat aus Kupfer, Nickel oder einer Legierung dieser Metalle besteht.

13. Verfahren nach einem der Ansprüche 1 bis 11, dadurch gekennzeichnet, daß das Substrat aus einem Metall/Kunststoff-Verbundwerkstoff besteht.

14. Verfahren nach Anspruch 13, dadurch gekennzeichnet, daß das Substrat aus mit einer Kupfer-Metallisierung versehenem Polyimid oder glasfaserverstärktem Epoxydharz besteht.

15. Gebondete, aluminlumhaltiges Material enthaltende Vorrichtung, hergestellt nach einem Verfahren nach einem der Ansprüche 1 bis 14.

16. Verwendung eines Substrats mit bondbarer metallischer Beschichtung, die eine Nickel enthaltende Schicht und eine die Oberfläche der Beschichtung bildende Gold enthaltende Schicht umfaßt, wobei die Beschichtung eine Kombination aus einer Nickel- oder Nickellegierungs-Schicht, einer Palladium- oder Palladiumlegierungs-Schicht und einer Gold- oder Goldlegierungs-Schicht ist und die Palladium- oder Palladiumlegierungs-Schicht zwischen der Nickel- oder Nickellegierungs-Schicht und der Gold- oder Goldlegierungs-Schicht angeordnet ist, zum Bonden von aluminiumhaltigen Materialien, insbesondere von Aluminiumdrähten.
